# EUROPEAN PATENT SPECIFICATION

(11) **EP 4 628 918 B1**
(45) Date of publication and mention of the grant of the patent: **19.08.2026**
(21) Application number: 25165052.9
(22) Date of filing: 20.03.2025
(51) Int. Cl.: G01R 31/42

(54) **ELECTRONIC LOAD DEVICE AND OPERATING METHOD THEREOF**
ELEKTRONISCHE LASTVORRICHTUNG UND BETRIEBSVERFAHREN DAFÜR
DISPOSITIF DE CHARGE ÉLECTRONIQUE ET SON PROCÉDÉ DE FONCTIONNEMENT

(30) Priority: 02.04.2024 TW 113112617
(43) Date of publication of application: 08.10.2025
(73) Proprietor: Chroma ATE Inc., Taoyuan City 333001 (TW)
(72) Inventor: Hu, Guei-Cheng, 333001 Taoyuan City (TW); Chen, Ling-Yi, 333001 Taoyuan City (TW); Hsu, Yu, 333001 Taoyuan City (TW)
(74) Representative: Schwarz & Partner Patentanwälte GmbH

(56) References cited:
- CN-A- 114 172 394
- CN-A- 117 706 410
- JIANG WEI ET AL: "Design and Implementation of a Low-Power Low-Cost Digital Current-Sink Electronic Load +", ENERGIES, vol. 12, no. 13, 7 July 2019 (2019-07-07), pages 2611, XP055860537, DOI: 10.3390/en12132611
- SHIQI AN: "High power DC electronic load", 2017 CHINESE AUTOMATION CONGRESS (CAC), IEEE, 20 October 2017 (2017-10-20), pages 1698 - 1701, XP033289629, DOI: 10.1109/CAC.2017.8243041

## Description

### BACKGROUND

### Technical Field

The present disclosure relates to the field of power supply testing, and in particular to an electronic load device and an operating method thereof.

### Related Art

An electronic load device can simulate an apparatus in an energy consuming state to test a power supply device. The power supply device is, for example, a device that can be used for providing a power supply or a power storage apparatus, such as a charging device. In a case where the power supply device provides an alternating-current (AC) voltage signal, the electronic load device can perform a procedure in a fixed current mode (for example, the electronic load device controls a conduction amount of an internal power component and continuously draws a fixed amount of current from the power supply device by the power component) to achieve the simulation of a power consumption environment. However, when the electronic load device performs the procedure in a fixed current mode, it is required to perform signal locking on the alternating-current voltage signal provided by the power supply device, and only after the signal locking is completed (for example, after one and a half cycles of the alternating-current voltage signal), can the fixed amount of current be continuously drawn from the power supply device to consume electric energy. If the electronic load device performing the procedure in a fixed current mode directly draws the current from the power supply device before the signal locking is completed, it may cause adverse effects, such as a backfeeding effect and a divergence effect, on the power supply device. Therefore, when the electronic load device performs a power consumption test on the power supply device, it needs a period of delay before it can perform power consumption simulation, so the power consumption simulation cannot be performed in time (that is, it cannot draw a fixed amount of current from the power supply device in time because of the period of delay). Examples of known methods for testing power supplies can be found in CN 117 706 410 A, CN 114 172 394 A, JIANG WEI ET AL: "Design and Implementation of a Low-Power Low-Cost Digital Current-Sink Electronic Load", ENERGIES, vol. 12, no. 13, 7 July 2019, and in SHIQI AN: "High power DC electronic load", 2017 CHINESE AUTOMATION CONGRESS (CAC), IEEE, 20 October 2017, pages 1698-1701.

### SUMMARY

In view of the above, the present disclosure provides an electronic load device and an operating method thereof. The electronic load device includes a power module, a detection module, and a processor. The power module draws a load current from device under test. The power module includes a switching load. The detection module detects an output voltage signal of the device under test. The processor is configured to operate the power module to control the load current as a first current signal according to the output voltage signal and a resistance parameter, where the initial phase of the first current signal is the same as the initial phase of the output voltage signal; input the output voltage signal to a phase lock loop model for signal locking; and generate a first pulse width modulation signal according to a received current parameter when the signal locking is completed, so that the switching load of the power module controls the load current to switch from the first current signal to a second current signal according to the first pulse width modulation signal.

The operating method for the electronic load device includes operating a power module to control a load current drawn from a device under test as a first current signal according to a resistance parameter and an output voltage signal detected from the device under test, where the initial phase of the first current signal is the same as the initial phase of the output voltage signal; inputting the output voltage signal to a phase lock loop model for signal locking; and generating a first pulse width modulation signal according to a received current parameter when the signal locking is completed, so that the switching load of the power module controls the load current to switch from the first current signal to a second current signal according to the first pulse width modulation signal.

Based on the above, according to some embodiments, the present disclosure can perform power consumption simulation in time during a power consumption test of the device under test (for example, draw a stable load current from the device under test in time without generating a backfeeding effect and a divergence effect) without a period of delay.

### BRIEF DESCRIPTION OF THE DRAWINGS

FIG. 1 is a schematic block diagram of an electronic load device in use according to some embodiments of the present disclosure.
FIG. 2 is a flowchart of an operating method of an electronic load device according to some embodiments of the present disclosure.
FIG. 3 is a schematic diagram of a phase lock loop model according to some embodiments of the present disclosure.
FIG. 4 is a schematic diagram of function modules implemented by a processor or another computing device according to some embodiments of the present disclosure.
FIG. 5 is a schematic diagram of a power module according to some embodiments of the present disclosure.
FIG. 6 is a schematic diagram of an output voltage signal and a load current of a device under test according to a first comparative example of the present disclosure.
FIG. 7 and FIG. 8 are schematic diagrams of an output voltage signal and a load current of a device under test according to a second comparative example of the present disclosure.
FIG. 9 is a schematic diagram of an output voltage signal and a load current of a device under test according to some embodiments of the present disclosure.

### DETAILED DESCRIPTION

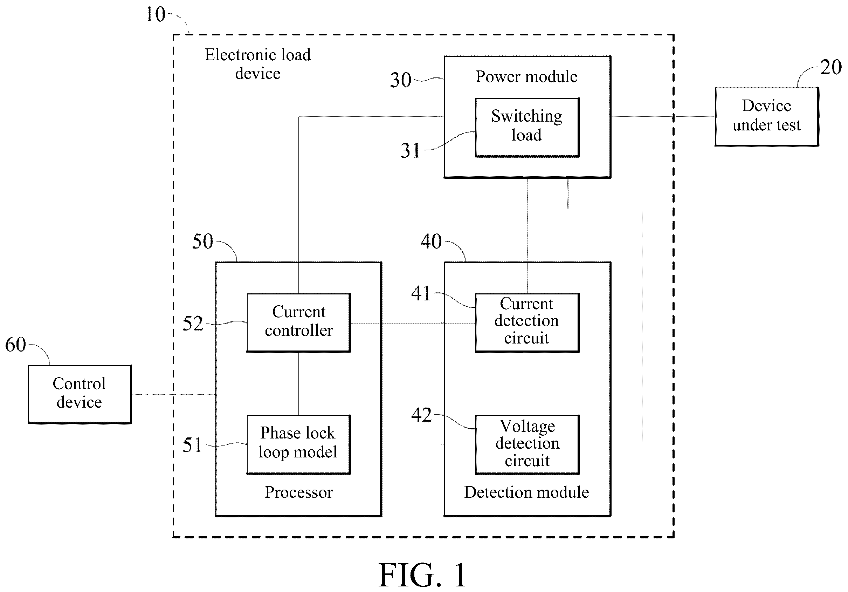

FIG. 1 is a schematic block diagram of an electronic load device 10 in use according to some embodiments of the present disclosure. The electronic load device 10 is connected to a device under test 20, so that the electronic load device 10 performs a power consumption test on the device under test 20. The device under test 20 is, for example, a power supply device provided with an alternating-current (AC) power supply. The electronic load device 10 includes a power module 30, a detection module 40, and a processor 50. The power module 30 is connected to the device under test 20, the detection module 40, and the processor 50, and the detection module 40 is connected to the processor 50. The power module 30 is configured to draw a load current from the device under test 20. The power module 30 includes a switching load 31. The switching load 31 is, for example, a bipolar transistor (BJT), a metal oxide semiconductor field effect transistor (MOSFET), an insulated gate bipolar transistor (IGBT), and similar power components. The detection module 40 is configured to detect an output power supply signal of the device under test 20. The output power supply signal includes an output current signal (i.e., the load current drawn by the power module 30 from the device under test 20) and an output voltage signal. For example, the detection module 40 includes a current detection circuit 41 and a voltage detection circuit 42. The current detection circuit 41 is configured to detect the output current signal of the device under test 20 through the power module 30. The voltage detection circuit 42 is configured to detect the output voltage signal of the device under test 20 through the power module 30. The current detection circuit 41 may be implemented by an ammeter, and the voltage detection circuit 42 may be implemented by a voltmeter. The electronic load device 10 is further connected to a control device 60 (such as a keyboard and a mouse). A user operates the control device 60 to transmit various instructions and various parameters to the processor 50 through an input/output interface (not shown) of the electronic load device 10. Thus, the processor 50 can perform corresponding operations in response to various instructions by using these parameters and the output power supply signal detected by the detection module 40. The processor 50 is, for example, but not limited to, a central processing unit, a microprocessor, an application-specific integrated circuit (ASIC), a system on a chip (SOC), or other arithmetic circuits.

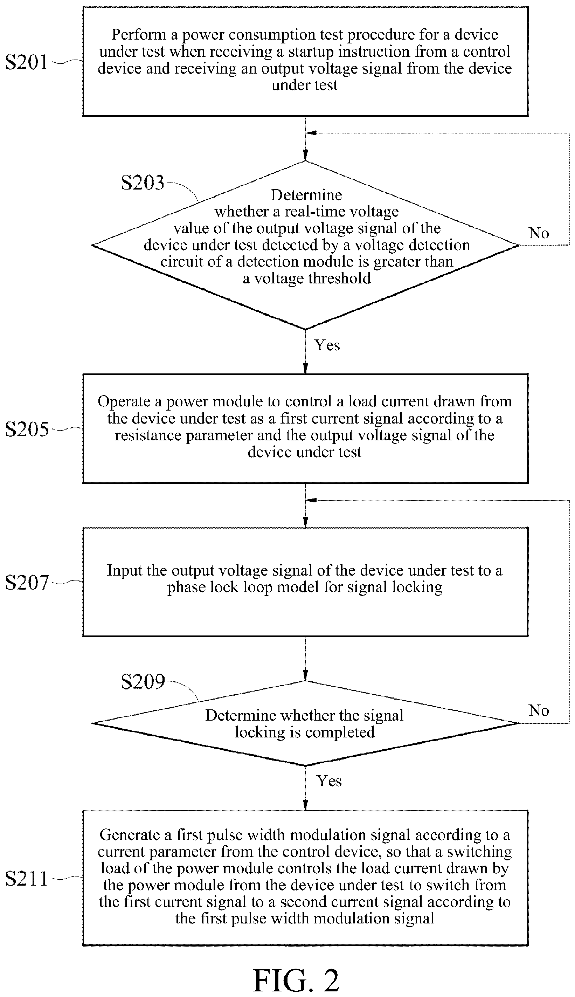

FIG. 2 is a flowchart of an operating method of an electronic load device 10 according to some embodiments of the present disclosure. A processor 50 of the electronic load device 10 is adapted to perform the operating method of an electronic load device 10 of the present disclosure for performing a power consumption test on the device under test 20. First, when the processor 50 receives a startup instruction from a control device 60 and receives an output voltage signal from the device under test 20, the processor 50 performs a power consumption test procedure for the device under test 20 (step S201). The power consumption test procedure includes step S203 to step S211.

In step S203, the processor 50 determines whether a real-time voltage value (specifically, its absolute value) of the output voltage signal of the device under test 20 detected by a voltage detection circuit 42 of a detection module 40 is greater than a voltage threshold to determine whether the output voltage signal of the device under test 20 is normal. If the real-time voltage value of the output voltage signal of the device under test 20 is greater than the voltage threshold, it indicates that the output voltage signal of the device under test 20 is normal (for example, the output voltage signal of the device under test 20 is stable), and in this case, the processor 50 performs step S205. If the real-time voltage value of the output voltage signal of the device under test 20 is not greater than the voltage threshold, it indicates that the output voltage signal of the device under test 20 is abnormal (for example, the output voltage signal of the device under test 20 is unstable), and in this case, the processor 50 repeats step S203 until the real-time voltage value of the output voltage signal of the device under test 20 is greater than the voltage threshold.

In step S205, the processor 50 operates a power module 30 to control a load current drawn from the device under test 20 as a first current signal according to a resistance parameter and the output voltage signal of the device under test 20. For example, the processor 50 divides the real-time voltage value of the output voltage signal by the resistance parameter to obtain a calculated current value. The processor 50 operates the power module 30 to control the load current drawn from the device under test 20 as the first current signal according to the calculated current value. A signal parameter of the first current signal (for example, a real-time current value thereof) corresponds to the calculated current value. Since the first current signal is formed based on the resistance parameter and the output voltage signal, the initial phase of the first current signal is the same as the initial phase of the output voltage signal of the device under test 20. Thereby, the electronic load device 10 can perform power consumption simulation on the device under test 20 in time without performing signal locking and waiting for the signal locking to be completed. That is, the electronic load device 10 can simulate electric energy consumption of the device under test 20 with the first current signal without a period of delay. When the power module 30 draws the first current signal from the device under test 20, the processor 50 performs step S207.

In step S207, the processor 50 inputs the output voltage signal of the device under test 20 to the phase lock loop model 51 for signal locking. In some embodiments, the phase lock loop model 51 is a function module implemented by the processor 50 or another computing device by using some arithmetic operations, which has the function (i.e., signal locking) of a physical phase lock loop circuit. That is, the phase lock loop model 51 may be a digital phase lock loop. In FIG. 1, the phase lock loop model 51 is implemented by the processor 50. Next, the processor 50 determines whether the signal locking is completed (step S209). If the signal locking is not completed, the processor 50 repeats signal locking in step S207. When the signal locking is completed, the processor 50 performs step S211.

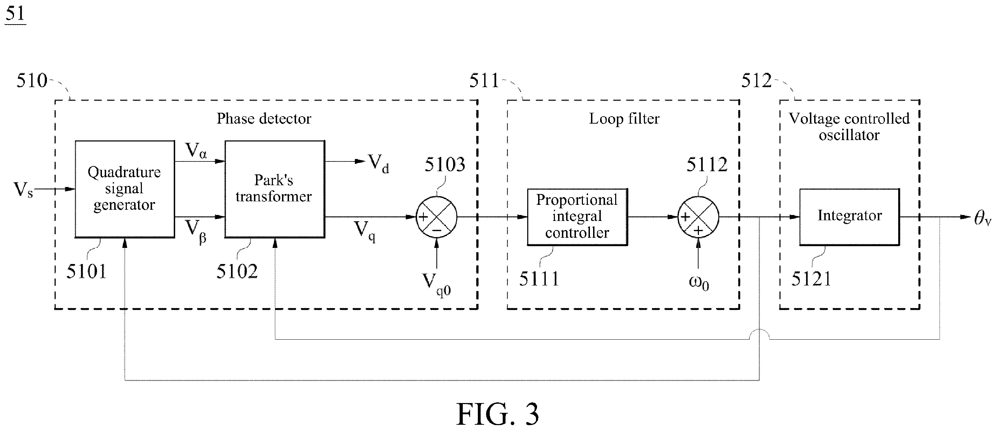

FIG. 3 is a schematic diagram of the phase lock loop model 51 according to some embodiments of the present disclosure. The description here is made in a case where the phase lock loop model 51 is a function module implemented by the processor 50 by using some arithmetic operations. The phase lock loop model 51 includes a phase detector 510, a loop filter 511, and a voltage controlled oscillator 512. The phase detector 510 is configured to detect a phase error between an output voltage signal Vₛ of the device under test 20 and an output oscillation signal θᵥ of the voltage controlled oscillator 512 to generate a phase error signal. The loop filter 511 filters the phase error signal to remove high-frequency noise to generate a filtered signal. The voltage controlled oscillator 512 generates the output oscillation signal θᵥ according to the filtered signal to indicate an estimated phase, and feeds the output oscillation signal θᵥ back to the phase detector 510. When the phase detector 510 detects that the estimated phase is the same as the phase of the output voltage signal Vₛ of the device under test 20 or the phase error between the estimated phase and the phase of the output voltage signal Vₛ of the device under test 20 is less than a phase threshold, it indicates that the phase lock loop model 51 has completed the signal locking of the output voltage signal Vₛ of the device under test 20.

For example, the phase detector 510 includes a quadrature signal generator 5101, a Park's transformer 5102, and a comparator 5103. The quadrature signal generator 5101 is, for example, a second-order generalized integrator-based quadrature-signal-generator (SOGI-QSG). The quadrature signal generator 5101 generates two quadrature voltage signals according to the output voltage signal Vₛ of the device under test 20. For example, the quadrature signal generator 5101 transforms the output voltage signal Vₛ of the device under test 20 into an α-axis vector V_{α} and a β-axis vector V_{β} in an αβ coordinate system. The Park's transformer 5102 performs Park's transformation on the α-axis vector V_{α} and the β-axis vector V_{β} to generate a d-axis vector V_{d} and a q-axis vector V_{q} in a dq coordinate system. The d-axis vector V_{d} represents the real-time voltage value of the output voltage signal Vₛ of the device under test 20. The q-axis vector V_{q} is the phase error signal mentioned above, which represents the phase error between the output voltage signal Vₛ of the device under test 20 and the output oscillation signal θᵥ of the voltage controlled oscillator 512. The comparator 5103 compares the q-axis vector V_{q} with a q-axis vector reference value V_{q0} (for example, a value of 0 or a value of 1). In an exemplary example, in a case where the q-axis vector reference value V_{q0} is the value of 0, if the q-axis vector V_{q} is the same as the q-axis vector reference value V_{q0}, then the phase lock loop model 51 has completed the signal locking of the output voltage signal Vₛ of the device under test 20. If the q-axis vector V_{q} is different from the q-axis vector reference value V_{q0}, then the phase lock loop model 51 has not completed the signal locking of the output voltage signal Vₛ of the device under test 20. In another exemplary example, in a case where the q-axis vector reference value V_{q0} is the value of 1, if the q-axis vector V_{q} (specifically, its absolute value) is less than the q-axis vector reference value V_{q0}, then the phase lock loop model 51 has completed the signal locking of the output voltage signal Vₛ of the device under test 20. If the q-axis vector V_{q} (specifically, its absolute value) is not less than the q-axis vector reference value V_{q0}, then the phase lock loop model 51 has not completed the signal locking of the output voltage signal Vₛ of the device under test 20.

The loop filter 511 includes a proportional integral controller (PI controller) 5111 and a frequency mixer 5112. The proportional integral controller 5111 generates a filtered signal according to the q-axis vector V_{q} to indicate an estimated angular velocity (or frequency). The frequency mixer 5112 mixes the filtered signal and a fundamental frequency reference value ω₀ (for example, an angular velocity reference value or a frequency reference value, which may be 60 Hz or 50 Hz) to generate a mixed signal, which can increase a response speed of the phase lock loop model 51. The frequency mixer 5112 further feeds the mixed signal back to the quadrature signal generator 5101. The voltage controlled oscillator 512 includes an integrator 5121. The integrator 5121 integrates the mixed signal to generate the output oscillation signal θᵥ, which indicates the estimated phase. The integrator 5121 feeds the output oscillation signal θᵥ back to the Park's transformer 5102. Thereby, the Park's transformer 5102 can adjust the q-axis vector V_{q} according to the output oscillation signal θᵥ.

Still referring to FIG. 2, in step S211, the processor 50 generates a first pulse width modulation signal according to a received current parameter from the control device 60, so that the switching load 31 of the power module 30 controls the load current drawn by the power module 30 from the device under test 20 to switch the first current signal to a second current signal according to the first pulse width modulation signal. For example, the processor 50 changes a duty cycle of the pulse width modulation signal outputted by the current controller 52 to a first duty cycle according to the current parameter from the control device 60 (e.g., a current signal related parameter such as a current effective value parameter and a peak current factor parameter) to form the first pulse width modulation signal. The current controller 52 is a function module implemented by the processor 50 or another computing device by using some arithmetic operations, which has the function of a physical pulse width modulation signal generation circuit. The physical pulse width modulation signal generation circuit may be a known or self-developed circuit, and its details are omitted here. In FIG. 1, the current controller 52 is implemented by the processor 50. The switching load 31 of the power module 30 changes its switching frequency to a first switching frequency according to the first pulse width modulation signal to control the load current drawn from the device under test 20 as the second current signal. A signal parameter of the second current signal corresponds to the current parameter from the control device 60. Since the signal locking of the output voltage signal of the device under test 20 has been completed, the phase of the second current signal is the same as the phase of the output voltage signal of the device under test 20, and the second current signal is fixed (e.g., its signal parameters such as peak current, current effective value, and current average value are fixed). In this way, the electronic load device 10 can switch the load current from the first current signal to a fixed amount of current (i.e., the second current signal) stably drawn from the device under test 20.

In some embodiments of step S211, after the signal locking of the output voltage signal of the device under test 20 is completed, the processor 50 analyzes the output voltage signal of the device under test 20 and determines whether the output voltage signal of the device under test 20 reaches zero crossing point. If the output voltage signal of the device under test 20 reaches the zero crossing point, then the processor 50 generates the first pulse width modulation signal according to the current parameter from the control device 60, so that the switching load 31 of the power module 30 controls the load current drawn by the power module 30 from the device under test 20 to switch from the first current signal to the second current signal according to the first pulse width modulation signal. In this way, the surge of the load current can be reduced. If the output voltage signal of the device under test 20 does not reach the zero crossing point, then the processor 50 keeps determining whether the output voltage signal of the device under test 20 reaches the zero crossing point until it determines that the output voltage signal of the device under test 20 reaches the zero crossing point.

In some embodiments of step S205, the processor 50 generates a second pulse width modulation signal according to the resistance parameter and the output voltage signal of the device under test 20, so that the switching load 31 of the power module 30 controls the load current as the first current signal according to the second pulse width modulation signal. For example, the processor 50 divides the real-time voltage value of the output voltage signal by the resistance parameter to obtain the calculated current value and changes the duty cycle of the pulse width modulation signal outputted by the current controller 52 to a second duty cycle according to the calculated current value to form the second pulse width modulation signal. The switching load 31 of the power module 30 changes its switching frequency to a second switching frequency according to the second pulse width modulation signal to control the load current drawn from the device under test 20 as the first current signal. The signal parameter of the first current signal corresponds to the calculated current value, and the second pulse width modulation signal is obtained based on the calculated current value. The signal parameter of the second current signal corresponds to the current parameter from the control device 60. The first pulse width modulation signal is obtained based on the current parameter from the control device 60. Therefore, when the calculated current value is matched with the current parameter from the control device 60 (for example, when the calculated current value is obtained by dividing the peak voltage of the output voltage signal by the resistance parameter and the calculated current value is the same as a peak current parameter obtained by multiplying the current effective value parameter of the current parameter from the control device 60 by the peak current factor parameter of the current parameter from the control device 60), the second pulse width modulation signal is the same as the first pulse width modulation signal (i.e., the second duty cycle is the same as the first duty cycle), the second switching frequency is the same as the first switching frequency, and the first current signal (specifically, its signal parameter) is the same as the second current signal (specifically, its signal parameter). When the calculated current value is not matched with the current parameter (for example, when the calculated current value is obtained by dividing the peak voltage of the output voltage signal by the resistance parameter and the calculated current value is different from the peak current parameter obtained by multiplying the current effective value parameter of the current parameter from the control device 60 by the peak current factor parameter of the current parameter from the control device 60), the second pulse width modulation signal is different from the first pulse width modulation signal (i.e., the second duty cycle is different from the first duty cycle), the second switching frequency is different from the first switching frequency, and the first current signal (specifically, its signal parameter) is different from the second current signal (specifically, its signal parameter).

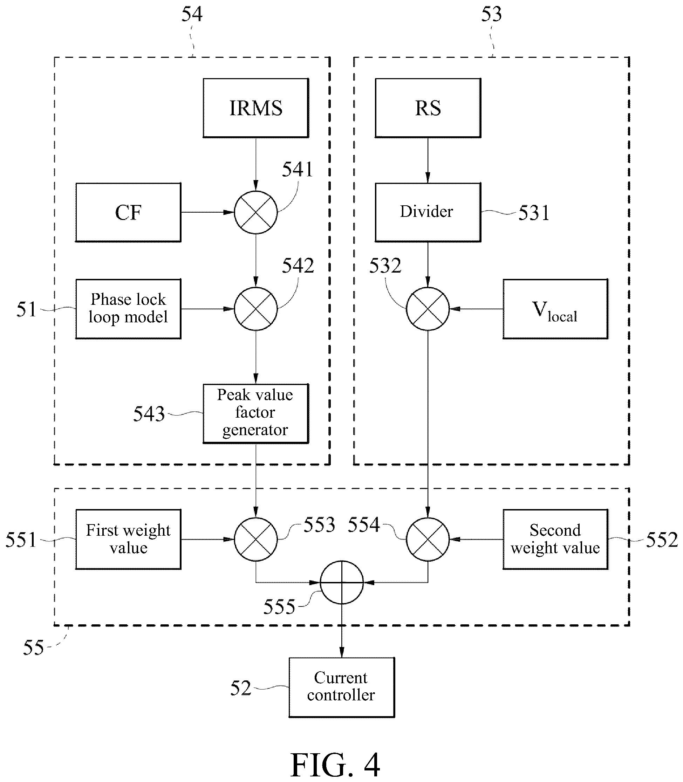

FIG. 4 is a schematic diagram of function modules implemented by a processor 50 or another computing device according to some embodiments of the present disclosure. In some embodiments, the processor 50 or another computing device implements function modules such as a current controller 52, a first current signal generator 53, a second current signal generator 54, and a duty cycle adjustment module 55 by using some arithmetic operations. In FIG. 4, the current controller 52, the first current signal generator 53, the second current signal generator 54, and the duty cycle adjustment module 55 are implemented by the processor 50. The current controller 52 outputs a pulse width modulation signal to the switching load 31 of the power module 30. The switching load 31 changes its switching frequency according to the pulse width modulation signal to draw the corresponding load current from the device under test 20. The first current signal generator 53 includes a divider 531 and a first multiplier 532. The divider 531 performs a reciprocal operation on a resistance parameter RS to generate a resistance reciprocal parameter. The first multiplier 532 multiplies the resistance reciprocal parameter by the real-time voltage value V_{local} of the output voltage signal of the device under test 20 to generate the calculated current value. The second current signal generator 54 includes a second multiplier 541, a mixer 542, a phase lock loop model 51, and a peak value factor generator 543. The second multiplier 541 multiplies a current effective value parameter IRMS of the current parameter from the control device 60 by a peak current factor parameter CF of the current parameter from the control device 60 to obtain the peak current parameter. The mixer 542 mixes the peak current parameter and the output oscillation signal θᵥ of the phase lock loop model 51 to generate a phase lock peak current parameter. For example, the mixer 542 substitutes the output oscillation signal θᵥ into a phase parameter in the peak current parameter expressed as a function to form a new function, and takes the new function as the phase lock peak current parameter. The peak value factor generator 543 performs a peak value factor operation on the phase lock peak current parameter to generate a phase lock current effective value parameter. For example, the peak value factor generator 543 divides the phase lock peak current parameter by a preset peak current factor parameter or by the peak current factor parameter CF of the current parameter from the control device 60 to generate the phase lock current effective value parameter.

The duty cycle adjustment module 55 of the processor 50 sends an instruction to the current controller 52. The instruction indicates a duty cycle to be executed by the current controller 52. The current controller 52 correspondingly changes the duty cycle of the outputted pulse width modulation signal according to the instruction. The duty cycle adjustment module 55 generates the second duty cycle according to the calculated current value and generates the first duty cycle according to the phase lock current effective value parameter. The duty cycle adjustment module 55 stores a first weight value 551 and a second weight value 552. There is a cross fade between the first weight value 551 and the second weight value 552. The cross fade is, for example, a linear fade or an exponential fade. The first weight value 551 corresponds to the first pulse width modulation signal (specifically, its first duty cycle), and the second weight value 552 corresponds to the second pulse width modulation signal (specifically, its second duty cycle). The duty cycle adjustment module 55 gradually adjusts the duty cycle indicated in the instruction sent to the current controller 52 from the second duty cycle to the first duty cycle according to the first weight value 551 and the second weight value 552. Thereby, the current controller 52 gradually adjusts the duty cycle of the outputted pulse width modulation signal from the second duty cycle to the first duty cycle according to the instruction to gradually switch the outputted pulse width modulation signal from the second pulse width modulation signal to the first pulse width modulation signal. The switching load 31 of the power module 30 gradually adjusts its switching frequency from the second switching frequency to the first switching frequency according to the pulse width modulation signal outputted by the current controller 52, so that the load current drawn from the device under test 20 is gradually switched from the first current signal to the second current signal.

In some embodiments, in a case where the cross fade is a linear fade, the first weight value 551 exhibits a linear fade in, and the second weight value 552 exhibits a linear fade out. Specifically, the first weight value 551 is complementary to the second weight value 552. For example, if the first weight value 551 is a value of "K", then the second weight value 552 is a value of "1-K". In some embodiments, in a case where the cross fade is an exponential fade, the first weight value 551 exhibits an exponential fade in, and the second weight value 552 exhibits an exponential fade out. For example, if the first weight value 551 is a value of "1-e⁻*^{αK}",* then the second weight value 552 is a value of *"e*^{*-*α*K*}".

In some embodiments, in a case where the first weight value 551 is complementary to the second weight value 552, the duty cycle adjustment module 55 calculates the duty cycle to be executed by the current controller 52 according to Formula 1. DTCE is the duty cycle to be executed by the current controller 52, DTC1 is the first duty cycle of the first pulse width modulation signal, DTC2 is the second duty cycle of the second pulse width modulation signal, the first weight value 551 is the value of "K", the second weight value 552 is the value of "1-K", and "K" is variable with time. $DTCE = DTC 1 \times K + DTC 2 \times \left(1-K\right)$

In some embodiments, in a case where the first weight value 551 exhibits an exponential fade in and the second weight value 552 exhibits an exponential fade out, the duty cycle adjustment module 55 calculates the duty cycle to be executed by the current controller 52 according to Formula 2. DTCE is the duty cycle to be executed by the current controller 52, DTC1 is the first duty cycle of the first pulse width modulation signal, DTC2 is the second duty cycle of the second pulse width modulation signal, the first weight value 551 is the value of "1*-e^{-αK}",* the second weight value 552 is the value of *"e^{-αK}",* "α" is a constant to control the speed of the fade in or out, and "K" is variable with time. $DTCE = DTC 1 \times \left(1-{e}^{- αK}\right) + DTC 2 \times {e}^{- αK}$

In some embodiments, the duty cycle adjustment module 55 includes a third multiplier 553, a fourth multiplier 554, and an adder 555. The third multiplier 553 is configured to implement a product of the first duty cycle of the first pulse width modulation signal and the first weight value 551 (hereinafter referred to as the first product). The fourth multiplier 554 is configured to implement a product of the second duty cycle of the second pulse width modulation signal and the second weight value 552 (hereinafter referred to as the second product). The adder 555 is configured to implement a sum of the first product and the second product.

The following is described in an example where the first weight value 551 is complementary to the second weight value 552. It is assumed that the calculated current value is obtained by dividing the peak voltage of the output voltage signal by the resistance parameter and the calculated current value is less than the peak current parameter obtained by multiplying the current effective value parameter of the current parameter from the control device 60 by the peak current factor parameter of the current parameter from the control device 60. In this case, the second duty cycle of the second pulse width modulation signal is less than the first duty cycle of the first pulse width modulation signal, the second switching frequency is less than the first switching frequency, and the peak current of the first current signal is less than the peak current of the second current signal.

Before the signal locking of the output voltage signal is completed, the duty cycle adjustment module 55 sets "K" associated with the first weight value 551 and the second weight value 552 to a value of 0. Therefore, before the signal locking of the output voltage signal is completed, the first weight value 551 is a value of 0, and the second weight value 552 is a value of 1. Thereby, before the signal locking of the output voltage signal is completed (for example, in step S205), the duty cycle adjustment module 55 controls the duty cycle of the pulse width modulation signal outputted by the current controller 52 as the second duty cycle to form the second pulse width modulation signal. The current controller 52 controls the switching frequency of the switching load 31 of the power module 30 as the second switching frequency, so that the load current drawn from the device under test 20 is the first current signal. After the signal locking of the output voltage signal is completed, the duty cycle adjustment module 55 gradually increases "K" associated with the first weight value 551 and the second weight value 552 from the value of 0 to the value of 1. Therefore, after the signal locking of the output voltage signal is completed, the first weight value 551 is gradually increased from the value of 0 to the value of 1, and the second weight value 552 is gradually decreased from the value of 1 to the value of 0. Thereby, after the signal locking of the output voltage signal is completed (for example, in step S211), the duty cycle adjustment module 55 controls the duty cycle of the pulse width modulation signal outputted by the current controller 52 to gradually increase from the second duty cycle to the first duty cycle to gradually change the second pulse width modulation signal to the first pulse width modulation signal. The current controller 52 controls the switching frequency of the switching load 31 of the power module 30 to gradually increase from the second switching frequency to the first switching frequency, so that the load current drawn from the device under test 20 is gradually increased from the first current signal to the second current signal. In this way, the processor 50 can perform power consumption simulation on the device under test 20 continuously and stably.

In some embodiments, the processor 50 receives a voltage parameter (for example, a voltage signal related parameter such as a voltage effective value parameter and a voltage peak factor parameter) inputted by the user from the control device 60. The processor 50 calculates the resistance parameter according to the voltage parameter and the current parameter from the control device 60. For example, the processor 50 divides the voltage effective value parameter of the voltage parameter by the current effective value parameter of the current parameter to obtain the resistance parameter. Alternatively, the processor 50 multiplies the voltage effective value parameter of the voltage parameter by the voltage peak factor parameter of the voltage parameter to obtain the voltage peak parameter, multiplies the current effective value parameter of the current parameter by the peak current factor parameter of the current parameter to obtain the peak current parameter, and divides the voltage peak parameter by the peak current parameter to obtain the resistance parameter.

In some examples, the processor 50 analyzes the output voltage signal of the device under test 20 to obtain the peak voltage of the output voltage signal, and calculates the resistance parameter according to the peak voltage and the current parameter. For example, the processor 50 or another computing device implements a peak value detection module, which has a function of a physical peak value detection circuit, by using some arithmetic operations. The peak value detection circuit may be a known or self-developed circuit, and its details are omitted here. The peak value detection module is configured to sample a peak value of a voltage signal. Thus, the output voltage signal is inputted by the processor 50 into the peak value detection module, and processed by the peak value detection module to obtain the peak voltage of the output voltage signal. The processor 50 multiplies the current effective value parameter of the current parameter by the peak current factor parameter of the current parameter to obtain the peak current parameter, and divides the peak voltage of the output voltage signal by the peak current parameter to obtain the resistance parameter. In this way, the resistance parameter can be obtained without the voltage parameter inputted by the user.

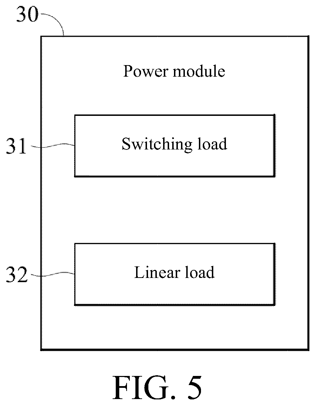

FIG. 5 is a schematic diagram of the power module 30 according to some embodiments of the present disclosure. In some embodiments, the power module 30 further includes a linear load 32. The resistance parameter is a resistance value of the linear load. The linear load 32 may be implemented by a passive component (e.g., a resistor). In step S205 of these embodiments, the processor 50 inputs the output voltage signal of the device under test 20 to the linear load 32. The linear load 32 generates the first current signal as the load current according to the resistance value of the linear load and the output voltage signal of the device under test 20. That is, in step S205 of these embodiments, the power module 30 draws the load current from the device under test 20 through the linear load 32. In step S211 of these embodiments, the processor 50 controls the power module 30 to draw the second current signal as the load current from the device under test 20 through the switching load 31 instead of the linear load 32.

In some embodiments, the processor 50 limits the peak current of the first current signal according to the current parameter from the control device 60. For example, the processor 50 or another computing device implements an amplitude limiter module, which has a function of a physical amplitude limiter circuit, by using some arithmetic operations. The amplitude limiter circuit may be a known or self-developed circuit, and its details are omitted here. The amplitude limiter module is configured to limit the peak current of the first current signal. It is assumed that the calculated current value is obtained by dividing the peak voltage of the output voltage signal by the resistance parameter. The processor 50 multiplies the current effective value parameter of the current parameter by the peak current factor parameter of the current parameter to obtain the peak current parameter. If the calculated current value is greater than the peak current parameter, it indicates that the peak current of the first current signal exceeds the expected range. Therefore, the processor 50 inputs the first current signal to the amplitude limiter module for processing to decrease the peak current of the first current signal to the peak current parameter. This can ensure the correctness of the power consumption simulation performed by the electronic load device 10.

In some embodiments, the processor 50 samples voltage values at two time points within a quarter wave of the output voltage signal of the device under test 20 and performs a differential operation to obtain a slope of the quarter wave of the output voltage signal. The processor 50 stores a comparison table, which defines different slope comparison values, and peak voltage comparison values, frequency comparison values, d-axis vector comparison values, q-axis vector comparison values, and estimated phase comparison values corresponding to the slope comparison values. The processor 50 finds a slope comparison value consistent with a calculated slope in the comparison table, and obtains corresponding peak voltage comparison value, frequency comparison value, d-axis vector comparison value, q-axis vector comparison value, and estimated phase comparison value in the comparison table according to the found slope comparison value. The processor 50 takes the peak voltage comparison value as the peak voltage of the output voltage signal of the device under test 20, the frequency comparison value as the frequency value of the output voltage signal of the device under test 20, the d-axis vector comparison value as the aforementioned d-axis vector V_{d} generated by the Park's transformer 5102, the q-axis vector comparison value as the aforementioned q-axis vector V_{q} generated by the Park's transformer 5102, and the estimated phase comparison value as the aforementioned estimated phase represented by the output oscillation signal θᵥ of the voltage controlled oscillator 512. In some embodiments, the processor 50 may input the calculated slope into a trained machine learning model to generate a peak voltage predicted value, a frequency predicted value, a d-axis vector predicted value, a q-axis vector predicted value, and an estimated phase predicted value through the trained machine learning model. The machine learning model may be a known or self-developed model, and its details are omitted here. The processor 50 takes the peak voltage predicted value as the peak voltage of the output voltage signal of the device under test 20, the frequency predicted value as the frequency value of the output voltage signal of the device under test 20, the d-axis vector predicted value as the aforementioned d-axis vector V_{d} generated by the Park's transformer 5102, the q-axis vector predicted value as the aforementioned q-axis vector V_{q} generated by the Park's transformer 5102, and the estimated phase predicted value as the aforementioned estimated phase represented by the output oscillation signal θᵥ of the voltage controlled oscillator 512. In this way, the processor 50 can quickly perform the signal locking of the output voltage signal of the device under test 20 according to the obtained peak voltage of the output voltage signal of the device under test 20, the frequency value of the output voltage signal of the device under test 20, the d-axis vector V_{d} of the Park's transformer 5102, the q-axis vector V_{q} of the Park's transformer 5102 and the estimated phase of the output oscillation signal θᵥ of the voltage controlled oscillator 512. That is, the time required by the signal locking of the output voltage signal of the device under test 20 can be shortened. Thus, in these embodiments, since the time required by the signal locking can be shortened, the processor 50 can skip step S205 and directly perform step S207 to step S211, so that the power module 30 does not need to control the load current of the device under test 20 as the first current signal, but directly and quickly controls the load current of the device under test 20 as the second current signal.

In some embodiments, the phase lock loop model 51 is implemented by a physical phase lock loop circuit. That is, the phase lock loop model 51 may be an analog phase lock loop. In some embodiments, the analog phase lock loop has a higher-order phase locking function than a digital phase lock loop, and thus, can complete the signal locking more quickly (i.e., the time required by the signal locking can be shortened). In these embodiments, since the time required by the signal locking can be shortened, the processor 50 can skip step S205 and directly perform step S207 to step S211, so that the power module 30 does not need to control the load current of the device under test 20 as the first current signal, but directly and quickly controls the load current of the device under test 20 as the second current signal.

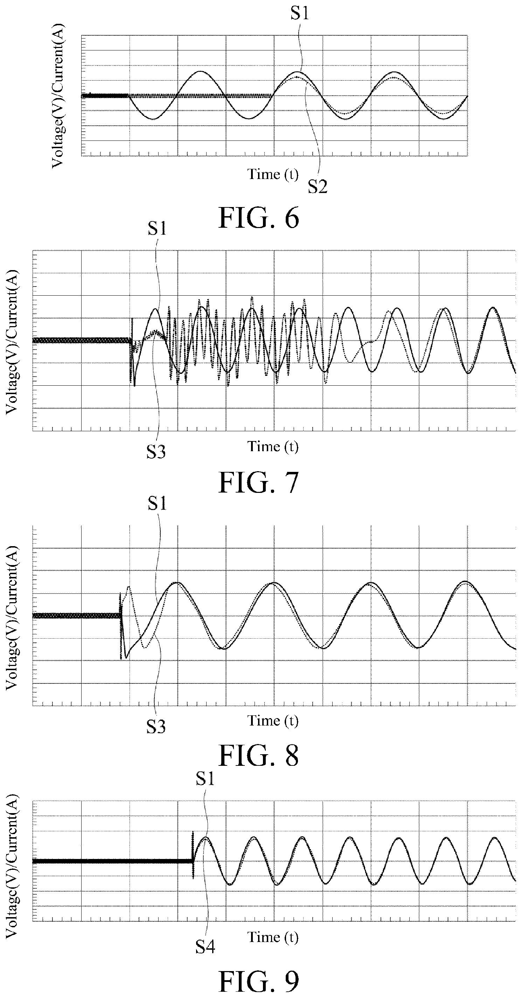

FIG. 6 is a schematic diagram of an output voltage signal and a load current of a device under test according to a first comparative example of the present disclosure. Curve S1 represents the output voltage signal of the device under test, and curve S2 represents the signal of the load current drawn from the device under test by the electronic load device of the first comparative example. In the first comparative example, the electronic load device simulates a power consumption environment by performing a procedure in a fixed current mode. As can be seen from FIG. 6, the electronic load device can only draw the load current from the device under test after a period of delay.

Referring to FIG. 7 and FIG. 8, FIG. 7 and FIG. 8 are schematic diagrams of an output voltage signal and a load current of a device under test according to a second comparative example of the present disclosure. Curve S1 represents the output voltage signal of the device under test, and curve S3 represents the load current drawn from the device under test by the electronic load device of the second comparative example. In the second comparative example, the electronic load device, when performing the procedure in a fixed current mode, directly draws the load current from the device under test before the signal locking is completed. As can be seen from FIG. 7 and FIG. 8, in this case, the load current may cause adverse effects such as a backfeeding effect and a divergence effect on the device under test.

FIG. 9 is a schematic diagram of the output voltage signal and the load current of the device under test 20 according to some embodiments of the present disclosure. Curve S1 represents the output voltage signal of the device under test, and curve S4 represents the load current drawn from the device under test 20 by the electronic load device 10 according to the some embodiments. As can be seen from FIG. 9, the electronic load device 10 can draw a stable current from the device under test 20 without a period of delay.

Based on the above, according to some embodiments, the present disclosure can perform power consumption simulation in time during a power consumption test of the device under test (for example, draw a stable load current from the device under test in time without generating a backfeeding effect and a divergence effect) without a period of delay.

## Claims

1. An electronic load device (10), comprising:
a power module (30), drawing a load current from a device under test (20), the power module (30) comprising a switching load (31);
a detection module (40), detecting an output voltage signal (Vₛ) of the device under test (20); and
a processor (50), configured to:
operate the power module (30) to control the load current as a first current signal according to the output voltage signal (Vₛ) and a resistance parameter, wherein the initial phase of the first current signal is the same as the initial phase of the output voltage signal (Vₛ);
**characterized in that** the electronic load device is further configured to
input the output voltage signal (Vₛ) to a phase lock loop model (51) for signal locking; and
generate a first pulse width modulation signal according to a received current parameter when the signal locking is completed, so that the switching load (31) of the power module (30) controls the load current to switch from the first current signal to a second current signal according to the first pulse width modulation signal.

2. The electronic load device (10) according to claim 1, wherein the processor (50) calculates the resistance parameter according to a received voltage parameter and the current parameter.

3. The electronic load device (10) according to claim 1, wherein the processor (50) analyzes the output voltage signal (Vₛ) to obtain a peak voltage of the output voltage signal (Vₛ) and calculates the resistance parameter according to the peak voltage and the current parameter.

4. The electronic load device (10) according to claim 1, wherein the power module (30) further comprises a linear load (32), and the resistance parameter is a resistance value of the linear load (32).

5. The electronic load device (10) according to claim 1, wherein the processor (50) generates a second pulse width modulation signal according to the output voltage signal (Vₛ) and the resistance parameter, so that the switching load (31) of the power module (30) controls the load current as the first current signal according to the second pulse width modulation signal.

6. The electronic load device (10) according to claim 5, wherein the processor (50) stores a first weight value (551) and a second weight value (552), there is a cross fade between the first weight value (551) and the second weight value (552), the first weight value (551) corresponds to the first pulse width modulation signal, the second weight value (552) corresponds to the second pulse width modulation signal, and the processor (50) gradually switches the second pulse width modulation signal to the first pulse width modulation signal according to the first weight value (551) and the second weight value (552), so that the switching load (31) of the power module (30) controls the load current to gradually switch from the first current signal to the second current signal.

7. The electronic load device (10) according to claim 1, wherein the processor (50) limits a peak current of the first current signal according to the current parameter.

8. An operating method of an electronic load device (10), comprising:
operating a power module (30) to control a load current drawn from a device under test (20) as a first current signal according to a resistance parameter and an output voltage signal (Vₛ) detected from the device under test (20), wherein the initial phase of the first current signal is the same as the initial phase of the output voltage signal (Vₛ); the method is **characterized by**
inputting the output voltage signal (Vₛ) to a phase lock loop model (51) for signal locking; and
generating a first pulse width modulation signal according to a received current parameter when the signal locking is completed, so that a switching load (31) of the power module (30) controls the load current to switch from the first current signal to a second current signal according to the first pulse width modulation signal.

9. The operating method of an electronic load device (10) according to claim 8, further comprising calculating the resistance parameter according to a received voltage parameter and the current parameter.

10. The operating method of an electronic load device (10) according to claim 8, further comprising analyzing the output voltage signal (Vₛ) to obtain a peak voltage of the output voltage signal (Vₛ) and calculating the resistance parameter according to the peak voltage and the current parameter.

11. The operating method of an electronic load device (10) according to claim 8, wherein the power module further comprises a linear load (32), and the resistance parameter is a resistance value of the linear load (32).

12. The operating method of an electronic load device (10) according to claim 8, wherein a second pulse width modulation signal is generated according to the output voltage signal (Vₛ) and the resistance parameter, so that the switching load (31) of the power module (30) controls the load current as the first current signal according to the second pulse width modulation signal.

13. The operating method of an electronic load device (10) according to claim 12, wherein the second pulse width modulation signal is gradually switched to the first pulse width modulation signal according to a first weight value (551) corresponding to the first pulse width modulation signal and a second weight value (552) corresponding to the second pulse width modulation signal, so that the switching load (31) of the power module (30) controls the load current to gradually switch from the first current signal to the second current signal, wherein there is a cross fade between the first weight value (551) and the second weight value (552).

14. The operating method of an electronic load device (10) according to claim 8, further comprising limiting a peak current of the first current signal according to the current parameter.

## Patentansprüche

1. Elektronische Lastvorrichtung (10), umfassend:
ein Leistungsmodul (30), das einen Laststrom aus einer zu testenden Vorrichtung (20) bezieht, wobei das Leistungsmodul (30) eine Schaltlast (31) umfasst;
ein Erfassungsmodul (40), das ein Ausgangsspannungssignal (Vₛ) der zu testenden Vorrichtung (20) erfasst; und
einen Prozessor (50), der eingerichtet ist:
das Leistungsmodul (30) derart zu betreiben, dass der Laststrom als erstes Stromsignal entsprechend dem Ausgangsspannungssignal (Vₛ) und einem Widerstandsparameter gesteuert wird,
wobei die Anfangsphase des ersten Stromsignals mit der Anfangsphase des Ausgangsspannungssignals (Vₛ) übereinstimmt;
**dadurch gekennzeichnet, dass** die elektronische Lastvorrichtung ferner dazu eingerichtet ist, das Ausgangsspannungssignal (Vₛ) zur Signalsynchronisation in ein Phasenregelkreis-Modell (51) einzugeben; und
ein erstes Pulsweitenmodulationssignal entsprechend einem empfangenen Stromparameter zu erzeugen, wenn die Signalsynchronisation abgeschlossen ist, so dass die Schaltlast (31) des Leistungsmoduls (30) den Laststrom so steuert, dass er entsprechend dem ersten Pulsweitenmodulationssignal von dem ersten Stromsignal zu einem zweiten Stromsignal umschaltet.

2. Elektronische Lastvorrichtung (10) nach Anspruch 1, wobei der Prozessor (50) den Widerstandsparameter entsprechend einem empfangenen Spannungsparameter und dem Stromparameter berechnet.

3. Elektronische Lastvorrichtung (10) nach Anspruch 1, wobei der Prozessor (50) das Ausgangsspannungssignal (Vₛ) analysiert, um eine Spitzenspannung des Ausgangsspannungssignals (Vₛ) zu ermitteln, und den Widerstandsparameter entsprechend der Spitzenspannung und dem Stromparameter berechnet.

4. Elektronische Lastvorrichtung (10) nach Anspruch 1, wobei das Leistungsmodul (30) ferner eine lineare Last (32) umfasst und der Widerstandsparameter ein Widerstandswert der linearen Last (32) ist.

5. Elektronische Lastvorrichtung (10) nach Anspruch 1, wobei der Prozessor (50) ein zweites Pulsweitenmodulationssignal entsprechend dem Ausgangsspannungssignal (Vₛ) und dem Widerstandsparameter erzeugt, so dass die Schaltlast (31) des Leistungsmoduls (30) den Laststrom als erstes Stromsignal entsprechend dem zweiten Pulsweitenmodulationssignal steuert.

6. Elektronische Lastvorrichtung (10) nach Anspruch 5, wobei der Prozessor (50) einen ersten Gewichtungswert (551) und einen zweiten Gewichtungswert (552) speichert,
wobei ein Überblenden zwischen dem ersten Gewichtungswert (551) und dem zweiten Gewichtungswert (552) erfolgt, der erste Gewichtungswert (551) dem ersten Pulsweitenmodulationssignal entspricht, der zweite Gewichtungswert (552) dem zweiten Pulsweitenmodulationssignal entspricht und der Prozessor (50) das zweite Pulsweitenmodulationssignal entsprechend dem ersten Gewichtungswert (551) und dem zweiten Gewichtungswert (552) graduell auf das erste Pulsweitenmodulationssignal umschaltet, sodass die Schaltlast (31) des Leistungsmoduls (30) den Laststrom so steuert, dass er graduell vom ersten Stromsignal auf das zweite Stromsignal umschaltet.

7. Elektronische Lastvorrichtung (10) nach Anspruch 1, wobei der Prozessor (50) einen Spitzenstrom des ersten Stromsignals entsprechend dem Stromparameter begrenzt.

8. Verfahren zum Betreiben einer elektronischen Lastvorrichtung (10), umfassend:
Betreiben eines Leistungsmoduls (30), zur Steuerung eines von einer zur testenden Vorrichtung (20) aufgenommenen Laststroms als erstes Stromsignal entsprechend einem Widerstandsparameter und einem von der zu testenden Vorrichtung (20) erfassten Ausgangsspannungssignal (Vₛ), wobei die Anfangsphase des ersten Stromsignals mit der Anfangsphase des Ausgangsspannungssignals (Vₛ) übereinstimmt;
wobei das Verfahren **gekennzeichnet ist durch** Einspeisen des Ausgangsspannungssignals (Vₛ) in ein Phasenregelkreis-Modell (51) zur Signalsynchronisierung; und Erzeugen eines ersten Pulsweitenmodulationssignals entsprechend einem empfangenen Stromparameter, wenn die Signalsynchronisation abgeschlossen ist, so dass eine Schaltlast (31) des Leistungsmoduls (30) den Laststrom so steuert, dass von dem ersten Stromsignal auf ein zweites Stromsignal entsprechend dem ersten Pulsweitenmodulationssignal umgeschaltet wird.

9. Verfahren zum Betreiben einer elektronischen Lastvorrichtung (10) nach Anspruch 8, das ferner das Berechnen des Widerstandsparameters entsprechend einem empfangenen Spannungsparameter und dem Stromparameter umfasst.

10. Verfahren zum Betreiben einer elektronischen Lastvorrichtung (10) nach Anspruch 8, das ferner das Analysieren des Ausgangsspannungssignals (Vₛ) umfasst, um eine Spitzenspannung des Ausgangsspannungssignals (Vₛ) zu erhalten, sowie das Berechnen des Widerstandsparameters entsprechend der Spitzenspannung und dem Stromparameter.

11. Verfahren zum Betreiben einer elektronischen Lastvorrichtung (10) nach Anspruch 8, wobei das Leistungsmodul ferner eine lineare Last (32) umfasst und der Widerstandsparameter ein Widerstandswert der linearen Last (32) ist.

12. Verfahren zum Betreiben einer elektronischen Lastvorrichtung (10) nach Anspruch 8, wobei ein zweites Pulsweitenmodulationssignal entsprechend dem Ausgangsspannungssignal (Vₛ) und dem Widerstandsparameter erzeugt wird, so dass die Schaltlast (31) des Leistungsmoduls (30) den Laststrom als erstes Stromsignal entsprechend dem zweiten Pulsweitenmodulationssignal steuert.

13. Verfahren zum Betreiben einer elektronischen Lastvorrichtung (10) nach Anspruch 12, wobei das zweite Pulsweitenmodulationssignal gemäß einem ersten Gewichtungswert (551), der dem ersten Pulsweitenmodulationssignal entspricht, und einem zweiten Gewichtungswert (552), der dem zweiten Pulsweitenmodulationssignal entspricht, graduell auf das erste Pulsweitenmodulationssignal umgeschaltet wird, so dass die Schaltlast (31) des Leistungsmoduls (30) den Laststrom so steuert, dass er graduell vom ersten Stromsignal auf das zweite Stromsignal umschaltet, wobei ein Überblenden zwischen dem ersten Gewichtungswert (551) und dem zweiten Gewichtungswert (552) stattfindet.

14. Verfahren zum Betreiben einer elektronischen Lastvorrichtung (10) nach Anspruch 8, das ferner das Begrenzen eines Spitzenstroms des ersten Stromsignals entsprechend dem Stromparameter umfasst.

## Revendications

1. Dispositif de charge électronique (10) comprenant:
un module de puissance (30) tirant un courant de charge à partir d'un dispositif à tester (20), le module de puissance (30) comprenant une charge de commutation (31);
un module de détection (40) détectant un signal de tension de sortie (Vₛ) du dispositif à tester (20); et
un processeur (50) configuré pour:
actionner le module de puissance (30) afin de contrôler le courant de charge sous forme d'un premier signal de courant en fonction du signal de tension de sortie (Vₛ) et d'un paramètre de résistance, la phase initiale du premier signal de courant étant identique à la phase initiale du signal de tension de sortie (Vₛ);
**caractérisé en ce que** le dispositif de charge électronique est en outre configuré pour:
introduire le signal de tension de sortie (Vₛ) dans un modèle de boucle à verrouillage de phase (51) pour le verrouillage du signal; et
générer un premier signal de modulation de largeur d'impulsion en fonction d'un paramètre de courant reçu lorsque le verrouillage du signal est terminé, de sorte que la charge de commutation (31) du module de puissance (30) contrôle le courant de charge pour passer du premier signal de courant à un second signal de courant en fonction du premier signal de modulation de largeur d'impulsion.

2. Dispositif de charge électronique (10) selon la revendication 1, dans lequel le processeur (50) calcule le paramètre de résistance en fonction d'un paramètre de tension reçu et du paramètre de courant.

3. Dispositif de charge électronique (10) selon la revendication 1, dans lequel le processeur (50) analyse le signal de tension de sortie (Vₛ) pour obtenir une tension de crête du signal de tension de sortie (Vₛ) et calcule le paramètre de résistance en fonction de la tension de crête et du paramètre de courant.

4. Dispositif de charge électronique (10) selon la revendication 1, dans lequel le module de puissance (30) comprend en outre une charge linéaire (32), et le paramètre de résistance est une valeur de résistance de la charge linéaire (32).

5. Dispositif de charge électronique (10) selon la revendication 1, dans lequel le processeur (50) génère un second signal de modulation de largeur d'impulsion en fonction du signal de tension de sortie (Vₛ) et du paramètre de résistance, de sorte que la charge de commutation (31) du module de puissance (30) contrôle le courant de charge en tant que premier signal de courant en fonction du second signal de modulation de largeur d'impulsion.

6. Dispositif de charge électronique (10) selon la revendication 5, dans lequel le processeur (50) stocke une première valeur de poids (551) et une seconde valeur de poids (552), il existe un fondu enchaîné entre la première valeur de poids (551) et la seconde valeur de poids (552), la première valeur de poids (551) correspond au premier signal de modulation de largeur d'impulsion, la seconde valeur de poids (552) correspond au second signal de modulation de largeur d'impulsion, et le processeur (50) passe progressivement du second signal de modulation de largeur d'impulsion au premier signal de modulation de largeur d'impulsion en fonction de la première valeur de poids (551) et de la seconde valeur de poids (552), de sorte que la charge de commutation (31) du module de puissance (30) contrôle le courant de charge pour passer progressivement du premier signal de courant au second signal de courant.

7. Dispositif de charge électronique (10) selon la revendication 1, dans lequel le processeur (50) limite un courant de crête du premier signal de courant en fonction du paramètre de courant.

8. Procédé d'actionnement d'un dispositif de charge électronique (10), comprenant:
actionner un module de puissance (30) afin de contrôler un courant de charge tiré à partir d'un dispositif à tester (20) sous forme d'un premier signal de courant en fonction d'un paramètre de résistance et d'un signal de tension de sortie (Vₛ), détecté à partir du dispositif à tester (20), la phase initiale du premier signal de courant étant identique à la phase initiale du signal de tension de sortie (Vₛ);
dans lequel le procédé est **caractérisé par**:
l'introduction du signal de tension de sortie (Vₛ) dans un modèle de boucle à verrouillage de phase (51) pour le verrouillage du signal; et
la génération d'un premier signal de modulation de largeur d'impulsion en fonction d'un paramètre de courant reçu lorsque le verrouillage du signal est terminé, de sorte qu'une charge de commutation (31) du module de puissance (30) contrôle le courant de charge pour passer du premier signal de courant à un second signal de courant en fonction du premier signal de modulation de largeur d'impulsion.

9. Procédé d'actionnement d'un dispositif de charge électronique (10) selon la revendication 8, comprenant en outre calculer le paramètre de résistance en fonction d'un paramètre de tension reçu et du paramètre de courant.

10. Procédé d'actionnement d'un dispositif de charge électronique (10) selon la revendication 8, comprenant en outre analyser le signal de tension de sortie (Vₛ) pour obtenir une tension de crête du signal de tension de sortie (Vₛ) et calculer le paramètre de résistance en fonction de la tension de crête et du paramètre de courant.

11. Procédé d'actionnement d'un dispositif de charge électronique (10) selon la revendication 8, dans lequel le module de puissance comprend en outre une charge linéaire (32), et le paramètre de résistance est une valeur de résistance de la charge linéaire (32).

12. Procédé d'actionnement d'un dispositif de charge électronique (10) selon la revendication 8, dans lequel un second signal de modulation de largeur d'impulsion est généré en fonction du signal de tension de sortie (Vₛ) et du paramètre de résistance, de sorte que la charge de commutation (31) du module de puissance (30) contrôle le courant de charge en tant que premier signal de courant en fonction du second signal de modulation de largeur d'impulsion.

13. Procédé d'actionnement d'un dispositif de charge électronique (10) selon la revendication 12, dans lequel le second signal de modulation de largeur d'impulsion est progressivement passé au premier signal de modulation de largeur d'impulsion en fonction d'une première valeur de poids (551) correspondant au premier signal de modulation de largeur d'impulsion et d'une seconde valeur de poids (552) correspondant au second signal de modulation de largeur d'impulsion, de sorte que la charge de commutation (31) du module de puissance (30) contrôle le courant de charge pour passer progressivement du premier signal de courant au second signal de courant, dans lequel il existe un fondu enchaîné entre la première valeur de poids (551) et la seconde valeur de poids (552).

14. Procédé d'actionnement d'un dispositif de charge électronique (10) selon la revendication 8, comprenant en outre limiter un courant de crête du premier signal de courant en fonction du paramètre de courant.
